# EUROPEAN PATENT APPLICATION

(11) **EP 1 843 400 A1**
(43) Date of publication of application: **10.10.2007**
(21) Application number: 06425176.2
(22) Date of filing: 16.03.2006
(51) Int. Cl.: H01L 33/00

(54) **Light emission device and corresponding manufacturing process**

(71) Applicant: Centro Ricerche Plast-Optica S.r.l., 33020 Amaro (Udine) (IT)
(72) Inventor: Sinesi, Sabino, 33020 Amaro (Udine) (IT); Rotaris, Gianluca, 33020 Amaro (Udine) (IT); Padovani, Sara, 33020 Amaro (Udine) (IT); Pairetti, Alberto, 33020 Amaro (Udine) (IT)
(74) Representative: Marchitelli, Mauro

(57) **Abstract**

Described herein is a light-emission device comprising one or more solid-state sources, obtained by positioning light-emitting chips (13) on a substrate (11), including a package (15; 25) for protection from agents that coats said chips (13). According to the invention, said package (15; 25) comprises a plurality of elements for diffusion (26) of the light coming from said one or more light-emitting chips (13).

## Description

The present invention relates to a light-emission device comprising one or more solid-state sources, obtained by positioning light-emitting chips on a substrate, including a package for protection from agents that coats said chip. The present invention also relates to a process for manufacturing said device.

It is known to provide light sources using devices such as light-emitting diodes (LEDs). Said sources can use one or more chip-LEDs or dies, it being usually understood with said term a multilayer semiconductor element that emits light radiation if supplied. Said light-emitting chips are positioned directly on the printed circuit. Some possible applications for said sources are devices for light signalling, headlights or other lights for motor vehicles, devices for public information, etc.

The aforementioned technique goes under the name of chip-on-board (COB) technology and usually envisages mounting arrays of chip-LEDs directly on the printed circuit via an initial process known as "die-bonding" (thermal or electro-thermal connection), associated to which are subsequent wire-bonding operations (for electrical connection of the LEDs to the circuit), and operations of packaging or protection of the source from the external agents.

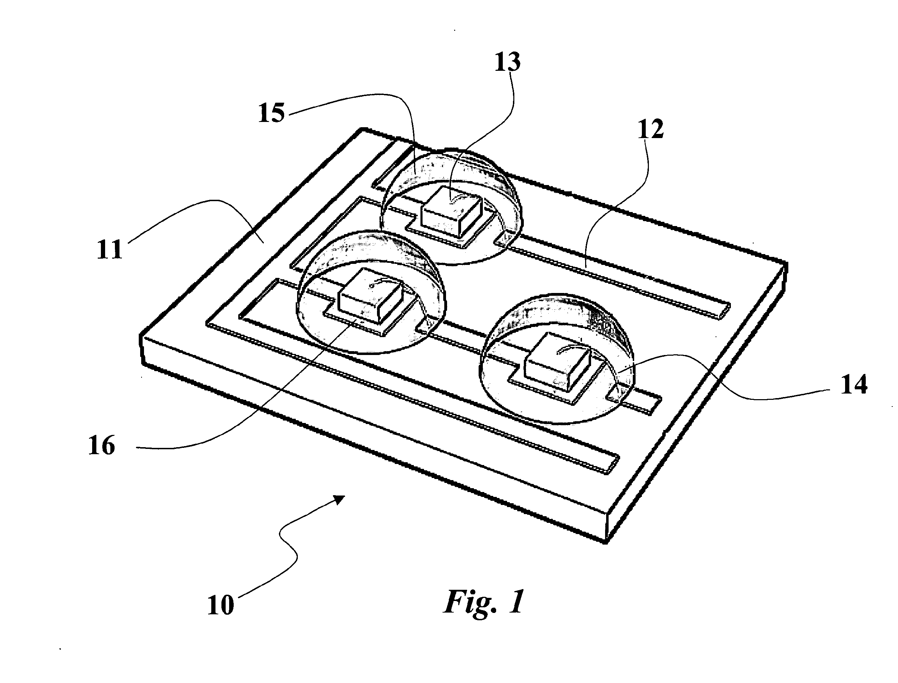

Figure 1 is a schematic and perspective view of a light source designated as a whole by the reference number 10. Said light source 10 comprises a substrate 11, in particular a printed circuit, which carries conductive paths 12 on which light-emitting chips 13 are bonded on purposely provided conductive pads 16 via a die-bonding process to obtain the array of light-emitting diodes (LEDs) 10. The reference number 14 designates an electrical-connection wire (wire-bonding operation) for providing said array of LED sources.

As may be noted from Figure 1, each of the chips 13 is coated during the packaging operation by a so-called "glob-top" 15, i.e., a substantially dome-shaped resin encapsulation, which, in addition to ensuring protection of the chip 13 from any possible external agents, also performs optical functions. Various types of resins and plastic materials can be used for packaging, for example, urethane or epoxy resins or acrylate resins.

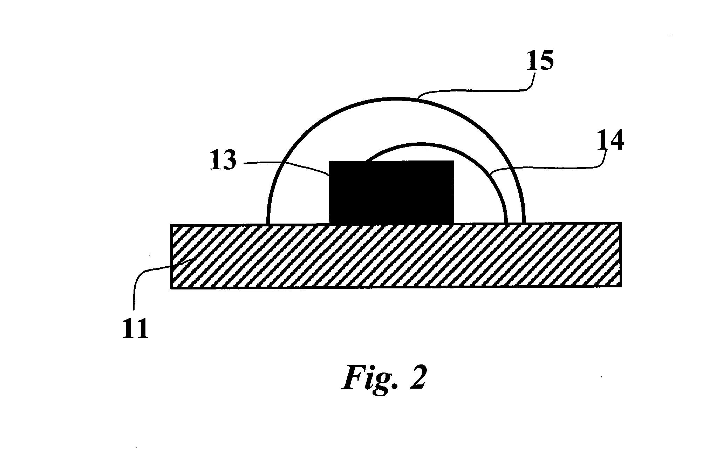

Figure 2 shows a lateral section of one of the chips 13 from which it is possible to appreciate the substantially spherical shape of the resin package that constitutes the glob-top 15. It should be noted that the package can also have other shapes, for example a cylindrical shape.

It is also possible to obtain multicoloured LEDs by depositing alongside one another a plurality of dies that emit at different wavelengths. Said plurality of dies is then coated with a single glob-top. Said structures are also referred to as multichip LEDs.

However, the multichip LEDs are far from suited to being coupled to optical devices such as lenses and/or mirrors, in so far as the optical designer must always position the focus of these structures in the centroid of the distribution of the dies, with the result that the eccentricities of the position of the sources with respect to the focus cause a systematic staggering of the angular distributions of the various colours emitted. Typically, what occurs is that at the edges of the pattern of emission there appear marked variations in the chromatic co-ordinates, in so far as the beams of the fundamental colours are not superimposed exactly on account of the aforementioned staggering. This defect is only apparently of lesser importance, but can represent a problem at the moment when, for example, it is desired to apply the light-emission devices described above to obtain signalling devices, such as, for example, traffic lights, in which the pattern of emission of each colour must be identical.

The problem is still more acutely felt in the case where it is desired to obtain an intermediate colour by merging the light emitted by a number of chips.

Known solutions envisage carrying out control of the radiation emitted by the chip through an external lens, obtained by casting, around the chip protected by the glob-top, which usually has only a protective function.

The purpose of the present invention is to solve the above problem in a simple and effective way.

With a view to achieving said purpose, the subject of the invention is a light-emission device having the characteristics indicated in the annexed Claim 1. The subject of the invention is also a process for manufacturing said light-emission device. Preferred embodiments of said device and process form the subject of the subsequent dependent claims.

The invention will now be described with reference to the annexed plate of drawings, which is provided purely by way of non-limiting example and in which:
- Figure 1 is a schematic perspective view of an example of light source according to the known art;
- Figure 2 is a detail of the light source of Figure 1; and
- Figure 3 represents a light source according to the invention.

The idea underlying the device according to the invention envisages making the glob-top package of resin via a series of very small and repeated jets of resin on the die, modulating the process parameters (resin viscosity, temperature of the substrate, shape of the nozzle, profile of the pressure during the jet, volume of resin of the jets, etc.) in such a way that, during the path in air from the nozzle to the substrate, the resin will englobe a large number of air bubbles, of dimensions much smaller than those of the die, i.e., in the region of tens of microns or even less, and will include them in the glob-top in a permanent way.

The above can be obtained, for example, by operating with process conditions tending to decreasing the viscosity of the resin with respect to the conditions in which a homogeneous glob-top without any air bubbles is obtained. By way of reference, commonly used acrylate resins have a viscosity in the region of 1300 centipoise (1300 mPa per second) to prevent entrapping of air. This can be obtained in particular using higher pressures as compared to normal process conditions and/or nozzles with smaller diameters or designed to favour inclusion of air by the drops of resin.

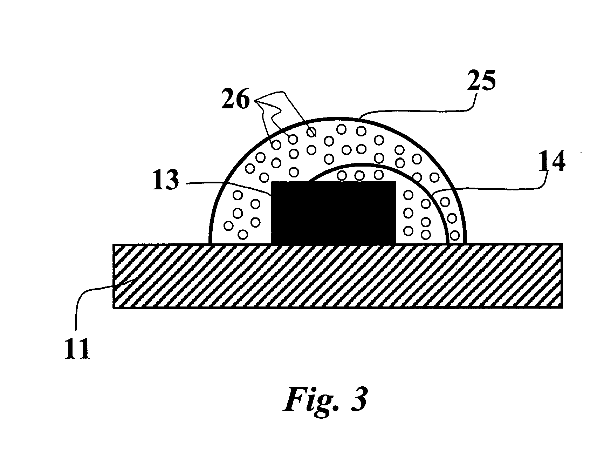

Figure 3 shows a lateral section of one of the chips 13 applied to which is a package 25 that incorporates inside it a plurality of air bubbles 26.

The package 25 containing the plurality of air bubbles 26 becomes a highly diffusing medium for the light emitted by the chip 13, and can merge the wavelengths of the light emitted by the various chips 13 in such a way that the light that comes out from the package 25 has a single value of chromatic co-ordinates over the entire surface. In this way, from the optical standpoint, the emission appears as if it occurred from the surface of the package 25, and no staggering occurs in the patterns of the various colours.

In an alternative embodiment, it is possible to envisage introducing diffusing particles in the process of deposition of the resin of the package. However, as compared to the use of diffusing particles of various nature such as, for example, metal powders, glass powders, or phosphors, the air bubbles simply diffuse the light without absorbing it or changing its colour. In addition, the air bubbles do not constitute a cost, nor do they entail any further processing stages.

From the above description the advantages of the device and process proposed herein emerge clearly.

Advantageously, the device in fact achieves an optimal diffusion of the light and a consequent optimal coupling with optical devices such as lenses and/or mirrors, without having to be concerned with the eccentricity of position of the sources with respect to the focus and with the corresponding staggering of the angular distributions of the various colours emitted, via simple modifications of parameters corresponding to just one step of the process of fabrication of the device, i.e., the step of deposition of the package. It should be noted that, instead, known processes for manufacturing dies with glob-tops are aimed at eliminating every air bubble from the resin package.

Of course, without prejudice to the principle of the invention, the details of construction and the embodiments may vary widely with respect to what is described and illustrated herein purely by way of example, without thereby departing from the scope of the present invention.

The distribution of diffusion elements or bubbles within the package may be uniform throughout the body or else assigned to just some layers of resin, provided that said distribution performs the task of diffusion of light of the light-emitting chips.

The inclusion of air bubbles may be obtained also via different processes, for example via processes of injection or bubbling of air or other gases in the resin, before or after deposition via the nozzle.

There may also be added in the package both diffusing elements, such as air bubbles, and phosphors used for wavelength conversion in white-light LEDs, in particular inorganic phosphors such as, for example, (Y, Gd)₃Al₅O₁₂ : Ce or Sr₂SiO₄ : Eu to be combined to chips that emit in the blue.

The light-emission device according to the invention is particularly suited for applications in which it is inserted in a headlight and/or other light of a motor vehicle, or else also in a light device for providing information to the public.

## Claims

1. A light-emission device comprising one or more solid-state sources, obtained by positioning one or more light-emitting chips (13) on a substrate (11), including a package (15; 25) for protection from agents that coats said one or more chips (13), said light-emission device being **characterized in that** said package (15; 25) comprises a plurality of elements for diffusion (26) of light coming from said one or more light-emitting chips (13).

2. The light-emission device according to Claim 1, **characterized in that** said diffusion elements (26) are air bubbles.

3. The light-emission device according to Claim 1 or Claim 2, **characterized in that** said diffusion elements (26) are distributed within the package (25) in a uniform way.

4. The light-emission device according to Claim 1 or Claim 2, **characterized in that** said diffusion elements (26) are distributed within the package (25) in layers.

5. The light-emission device according to one or more of Claims 1 to 4, **characterized in that** said package (15; 25) comprises light-diffusion elements coming from said one or more light-emitting chips (13) and elements for the wavelength conversion of the light coming from said one or more light-emitting chips (13).

6. The light-emission device according to one or more of the preceding claims, **characterized in that** it is inserted in a signalling device.

7. The light-emission device according to one or more of the preceding Claims 1 to 5, **characterized in that** it is inserted in a headlight and/or other light of a motor vehicle.

8. The light-emission device according to one or more of the preceding Claims 1 to 5, **characterized in that** it is inserted in a lighting device for providing information to the public.

9. A process for manufacturing an emission device, which comprises the operations of positioning light-emitting chips (13) on a substrate (11) and depositing a package (15; 25) for protection from agents on said light-emitting chips (13), **characterized in that** said operation of deposition comprises the operation of introducing a plurality of diffusion elements (26) into said package.

10. The process according to Claim 9, **characterized in that** said operation of introducing a plurality of diffusion elements (26) into said package (25) comprises introducing air bubbles.

11. The process according to Claim 10, **characterized in that** said operation of introducing air bubbles (26) into the package (25) comprises the operation of decreasing the viscosity of a resin constituting the package as compared to normal process parameters.

12. The process according to Claim 11, **characterized in that** said decrease in viscosity is obtained via an increase in pressure.

13. The process according to Claim 9, **characterized in that** said operation of deposition of the package (25) comprises performing repeated jets of resin or plastic material by means of a nozzle on the light-emitting chips (13), modulating parameters of the operation of deposition selected within a set comprising viscosity of the resin, temperature of the substrate, shape of the nozzle, profile of the pressure during the jet, and volume of resin of the jets, in order to include air during the path in air of the resin from the nozzle to the substrate.

14. The process according to Claim 9, **characterized in that** said operation of deposition envisages introducing air into the resin before deposition of the package (25).

15. The process according to Claim 9, **characterized in that** said operation of deposition envisages introducing air into the resin after deposition of the package(25).

16. The process according to one or more of Claims 9 to 15, **characterized in that** it comprises the operation of introducing into said package (15; 25) elements for wavelength conversion of the light coming from said one or more light-emitting chips (13) together with said elements for diffusion (26) of light coming from said one or more light-emitting chips (13).
